# FASCICULE DE BREVET EUROPEEN

(11) **EP 1 685 595 B1**
(45) Date de publication et mention de la délivrance du brevet: **13.11.2013**
(21) Numéro de dépôt: 04805343.3
(22) Date de dépôt: 29.10.2004
(51) Int. Cl.: H01L 23/473, H05K 7/20

(54) **DISPOSITIF DE REFROIDISSEMENT D'UNE ELECTRONIQUE DE PUISSANCE**
LEISTUNGSELEKTRONIK-KÜHLEINRICHTUNG
POWER-ELECTRONIC-COOLING DEVICE

(30) Priorité: 31.10.2003 FR 0312776
(43) Date de publication de la demande: 02.08.2006
(73) Titulaire: VALEO EQUIPEMENTS ELECTRIQUES MOTEUR, 94017 Créteil-Cedex (FR)
(72) Inventeur: RONDIER, Patrick, F-95360 Montmagny (FR); FAKES, Michel, F-59113 Seclin (FR); VASILESCU, Claudiu, F-75020 Paris (FR); TELLIER, Richard, F-75011 Paris (FR)
(74) Mandataire: de Lambilly Delorme, Marie Pierre
(86) Numéro de dépôt international: PCT/FR2004/002789
(87) Numéro de publication internationale: WO 2005/043621

(56) Documents cités:
- EP-A- 0 124 428
- US-A1- 2003 178 179
- US-B1- 6 397 935

## Description

### Domaine de l'invention

L'invention concerne un dispositif de refroidissement d'une électronique de puissance, notamment l'électronique de puissance permettant de commander un alternateur ou un alterno-démarreur de véhicule automobile. L'invention trouve des applications dans le domaine de l'électronique de puissance. Elle peut s'appliquer à l'électronique de puissance des véhicules automobiles. En particulier, elle peut s'appliquer à des convertisseurs DC/DC pour véhicules automobiles.

### Etat de la technique

Dans un véhicule automobile, l'alternateur permet de transformer un mouvement de rotation du rotor inducteur, entraîné par le moteur thermique du véhicule, en un courant électrique induit dans les bobinages du stator.

Actuellement, il existe des alternateurs réversibles, qui peuvent constituer un moteur électrique permettant d'entraîner en rotation, via l'arbre du rotor, le moteur thermique du véhicule. Un tel alternateur réversible est appelé alterno-démarreur. Il permet de transformer l'énergie mécanique en une énergie électrique et vice versa. Ainsi, un alterno-démarreur peut démarrer le moteur du véhicule automobile et constituer un moteur auxiliaire permettant d'aider le moteur thermique du véhicule pour entraîner ledit véhicule automobile.

L'alternateur, ou l'alterno-démarreur, du véhicule est en partie commandé par une électronique de puissance qui peut former un module de puissance séparé de l'alternateur et connecté à ce dernier au moyen de câbles électriques.

En général, ce module de puissance (comme la plupart des modules de puissance présents dans un véhicule) comporte au moins un composant électronique de puissance brasé ou collé sur un substrat. Ce substrat peut être un substrat de type DBC (Direct Bounded Copper, en termes anglo-saxons). Un tel substrat comporte trois couches : une première couche est constituée d'une trace métallique gravée formant les liaisons électriques du circuit, une deuxième couche intermédiaire est une plaque de matériau électriquement isolant tel qu'une céramique et une troisième couche est une plaque métallique constituée de cuivre ou de cuivre nickelé. L'ensemble constitué du substrat DBC et des composants électroniques de puissance est à son tour brasé sur une plaque de cuivre, formant un support mécanique et un dissipateur thermique.

Le substrat peut aussi être de type SMI (Substrat Métallique Isolé). Dans ce cas, la plaque de céramique est remplacée par une plaque de résine pouvant supporter une première couche constituée d'une trace métallique de cuivre très fine. La troisième couche de dissipation thermique peut, dans ce cas, être constituée d'une plaque métallique en aluminium.

La plaque métallique, en aluminium pour le substrat SMI et en cuivre pour le substrat DBC, comporte une face de refroidissement destinée à être mise en contact avec des moyens de refroidissement par air, généralement extérieurs au module de puissance.

Ces moyens de refroidissement sont généralement un dissipateur à ailettes placé sous le module de puissance. L'air ambiant qui circule entre les ailettes de ce dissipateur assure le refroidissement du module de puissance. Or, cet air ambiant peut être réchauffé, par exemple, par les différents éléments et circuits environnants qui diffusent eux aussi de la chaleur. De tels moyens de refroidissement par air peuvent alors présenter une capacité à refroidir insuffisante, en particulier lorsque le module de puissance génère une forte puissance et, par conséquent, dissipe une forte chaleur.

On connaît un document US 2003/178179 A1 qui décrit un échangeur de chaleur pour refroidir des composants électroniques. Cet échangeur comporte un premier boîtier et un second boîtier emboîté dans le premier boîtier de manière à former un canal de circulation d'un liquide de refroidissement de moteur à combustion.

### Exposé de l'invention

L'invention a justement pour but de remédier aux inconvénients de la technique exposée précédemment. A cette fin, elle propose un dispositif pour refroidir une électronique de puissance, par exemple destinée au contrôle ou la commande d'un alternateur ou d'un alterno-démarreur, par circulation d'un liquide dans un circuit de refroidissement situé sous l'électronique de puissance, ce liquide pouvant être de l'eau ou un liquide spécifique au refroidissement.

A cet effet, l'invention a pour objet un dispositif de refroidissement d'une électronique tel qu'énoncé à la revendication 1 et son procédé d'assemblage selon la revendication 7.

L'invention est avantageusement complétée par les différentes caractéristiques suivantes, prises seules ou selon toutes leurs combinaisons possibles :
- le circuit de refroidissement comporte des déflecteurs situés dans les canaux de circulation du liquide.

Ces déflecteurs permettent de bien guider le fluide dans les canaux et de réduire ainsi les pertes de charge. Ces déflecteurs permettent également d'améliorer le refroidissement en augmentant les surfaces d'échange thermique.
- le circuit de refroidissement comporte des turbulateurs répartis dans les canaux de circulation du liquide afin d'améliorer encore le refroidissement.
- les canaux du circuit de refroidissement sont réalisés par emboutissage d'une première plaque de métal ce qui constitue une manière simple et économique de réaliser un dispositif de refroidissement, ce dispositif pouvant comporter un réseau complexe de canaux, déflecteurs et de turbulateurs. De plus, réaliser les canaux de refroidissement par emboutissage permet d'obtenir un dispositif de refroidissement léger.
- le circuit de refroidissement est fixé sous le plateau-support par brasage. Ainsi, la réalisation des canaux de refroidissement est effectuée par une simple opération de brasage.
- le circuit de refroidissement comporte une seconde plaque de métal fixée entre le plateau-support et la première plaque de métal. Cette seconde plaque permet ainsi d'augmenter aisément l'épaisseur du plateau support.
- la seconde plaque de métal est plane, brasée sur la première plaque de métal.
- le métal est de l'aluminium.

### Brève description des dessins

La figure 1 représente l'électronique de puissance d'un alternateur avec un dispositif de refroidissement selon l'invention.
La figure 2 représente le circuit de refroidissement du dispositif de l'invention.
La figure 3 représente un exemple de plaque emboutie du circuit de refroidissement de la figure 2.
La figure 4 représente la jointure entre la tubulure d'arrivée et de sortie du liquide de refroidissement et le circuit de refroidissement.
La figure 5 représente un exemple d'un dispositif de refroidissement ne faisant pas partie de l'invention selon une vue éclatée.
La figure 6 représente le dispositif de refroidissement de la figure 5 selon une vue en perspective.

### Description détaillée de modes de réalisation de l'invention

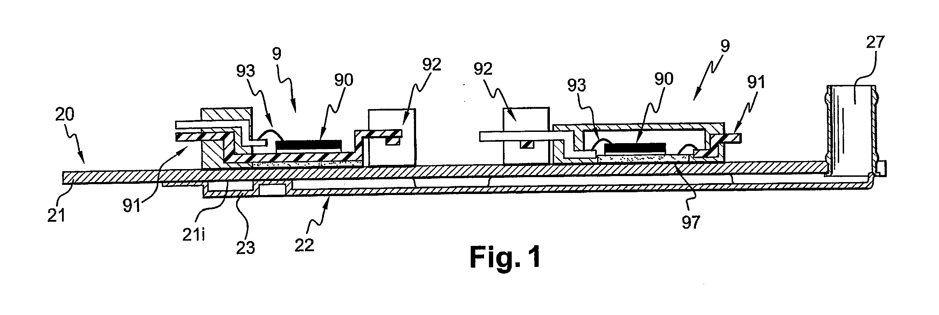

La figure 1 représente un exemple de circuit électronique de puissance pour alternateur ou alterno-démarreur monté sur un dispositif de refroidissement selon l'invention. Dans l'exemple de la figure 1, l'électronique de puissance, ou module de puissance, est référencée 9. Cette électronique de puissance 9 peut comporter, par exemple, un substrat de type DBC sur lequel sont montés un ou plusieurs circuit(s) intégré(s) 90. Ces circuits intégrés 90 peuvent être connectés, par exemple, à des composants discrets comme des capacités 92. La connexion peut se faire, par exemple, par des fils de connexion 93 (wire-bonding, en termes anglo-saxons) ou par l'intermédiaire de traces de conductrices 91, appellées bus-bar.

L'ensemble de l'électronique de puissance 9 est fixé sur un plateau de support, appelé plateau-support 21.

Il est bien entendu que le module de puissance 9 représenté sur cette figure 1 n'est qu'un exemple de module de puissance. D'autres modules de puissance peuvent bien sûr être montés sur le plateau-support 21 du dispositif de refroidissement de l'invention. D'une façon générale, l'électronique de puissance peut être montée sur le plateau-support de la même façon que sur un plateau dissipateur de l'art antérieur.

La figure 1 montre l'électronique de puissance 9 montée sur le dispositif de refroidissement de l'invention. Ce dispositif de refroidissement, référencé 20, comporte le plateau-support 21 sur lequel est montée et fixée l'électronique de puissance 9. Il comporte, en outre, un circuit de refroidissement 22 situé sous le plateau-support 21. Le circuit de refroidissement 22 comporte une plaque emboutie 23, ou première plaque, qui comporte des canaux destinés à la circulation d'un liquide de refroidissement tel que de l'eau. Cette plaque emboutie est positionnée sous le plateau-support 21. En fait, c'est la plaque emboutie elle-même qui forme, par ses motifs d'emboutissage et par la face inférieure 21 i du plateau support 21, les canaux de circulation de l'eau. De cette façon, la circulation du liquide de refroidissement sur cette plaque emboutie 23 et, par conséquent, sous le plateau 21 supportant l'électronique de puissance permet de refroidir ladite électronique de puissance.

Comme on vient de le dire, le liquide de refroidissement peut être de l'eau. On parlera, dans la suite de la description, de refroidissement par eau. Il est bien entendu, toutefois, que l'on peut utiliser, dans le dispositif de l'invention, tous les fluides de refroidissement connus.

La figure 1 montre que le dispositif de refroidissement de l'invention comporte également au moins une tubulure 27 d'arrivée et de sortie de l'eau. Cette tubulure 27 permet, respectivement, d'introduire et d'évacuer l'eau du circuit de refroidissement 22.

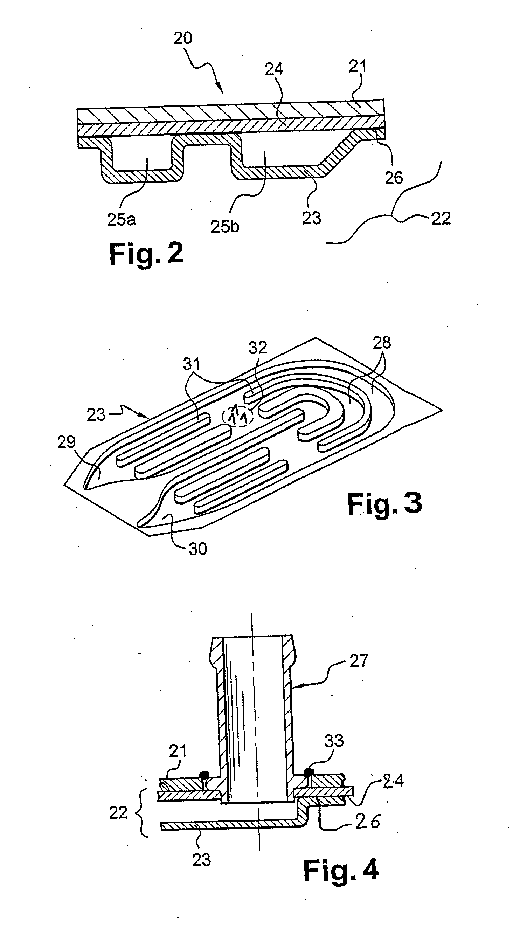

La figure 2 montre, d'une façon plus détaillée, le dispositif de refroidissement de l'invention. Comme on l'a vu précédemment, le dispositif de refroidissement 20 de l'invention comporte un plateau-support 21 sur lequel est montée l'électronique de puissance à refroidir. Dans le mode de réalisation de la figure 1, on a montré le circuit de refroidissement 22 placé directement sous le plateau-support 21.

Dans un mode de réalisation de l'invention, le circuit de refroidissement 22 comporte, en plus de la plaque emboutie 23, une seconde plaque 24 fixée au-dessus de la plaque emboutie 23. Cette seconde plaque 24 est plane, fixée sous le plateau-support 21. Dans ce cas, la plaque plane 24 est assemblée sur la face inférieure 21i du plateau-support 21 par une technique qui peut être identique à la technique d'assemblage de la plaque emboutie 23 avec la plaque plane 24, décrite ci-après.

L'ensemble constitué par le plateau-support 21 et le plaque plane 24 forme une semelle pour l'électronique de puissance. Cette seconde plaque intermédiaire 24, placée entre le plateau-support 21 et la plaque emboutie 23 permet d'obtenir un plateau-support de plus grande épaisseur. Il pourrait être envisager d'avoir plusieurs plaques intermédiaires. L'ensemble constitué par le plateau-support et la ou les plaques intermédiaires 24 constitue un plateau support sur lequel, est montée d'un coté l'électronique de puissance à refroidir et sur l'autre coté est placé le dispositif de refroidissement de l'électronique de puissance. Cette seconde plaque permet aussi de porter les tubulures comme décrit ci-après.

Selon un mode de réalisation de l'invention, la plaque emboutie 23 est fixée sur la plaque plane 24 par brasage. La référence 26 représente les joints de brasure utilisés pour assembler la plaque emboutie 23 et la plaque plane 24 par brasage. Dans le mode de réalisation de la figure 1, la plaque emboutie 23 est assemblée directement sur le plateau-support 21, par une technique de brasage. Cette technique de brasage consiste à assembler deux plaques d'un même matériau, par exemple en aluminium, séparées par une couche de plaquage, ou joint de brasure, déposée sur l'une des plaques. Ces deux plaques sont ensuite chauffées dans un four à la température de fusion du plaquage. La couche de plaquage, dans le cas ou les deux plaques à braser sont aluminium est également en aluminium mais possède une température de fusion inférieure à celle des deux plaques à assembler. Cette couche de plaquage, ici en aluminium est déposée selon une technique de colaminage sur une face d'au moins une des deux plaques à braser, cette face étant en regard avec l'autre face à braser. Le plaquage étant du même matériau que les deux plaques à assembler, il n'y a pas ajout de barrière thermique ce qui permet d'obtenir une bonne conductivité thermique.

En l'absence de plaque intermédiaire 24, selon cette technique de brasage aux moyens de plaques colaminées, une plaque colaminée étant une plaque dotée de son plaquage, alors soit le plateau-support 21 présente sur sa face inférieure un plaquage, soit la plaque emboutie 23 présente sur sa face supérieure un plaquage.

Le plateau-support 21 et la plaque plane 24 peuvent avoir des épaisseurs différentes. De même, l'épaisseur de la plaque emboutie 23 peut être différente de celle de la plaque plane 24 et du plateau-support 21.

Le plateau-support peut être réalisé par une seule plaque métallique d'une épaisseur de l'ordre de 1 à 10 mm. Il peut aussi être réalisé à partir de plusieurs plaques assemblées, par exemple par brasage comme décrit précédement.

Chacune des plaques, plaque plane ou plaque emboutie, peut elle-même être réalisée à partir de plusieurs plaques assemblées, par exemple par brasage.

La plaque emboutie 23 a une épaisseur de l'ordre de 0,5 à 3 mm. La face supérieure de la plaque emboutie, c'est-à-dire la face qui est assemblée avec le plateau-support 21 ou la plaque plane 24, peut servir d'apport de matière lors de l'assemblage par brasage. Cet apport de matière est constitué par le plaquage en contact avec l'autre plaque ou support à braser.

Autrement dit, les parties de la plaque emboutie qui ne forment pas les canaux 28 sont en contact direct avec la plaque plane 24 ou le plateau-support 21. Ces parties en contact forment le joint de brasure 26.

Avantageusement, la plaque emboutie 23 et la plaque plane 24 sont réalisées dans un matériau métallique tel que de l'aluminium. L'aluminium présente l'avantage d'avoir une bonne conductivité à la chaleur. Il permet ainsi au dispositif de l'invention d'avoir un bon coefficient d'échange.

Comme les plaques 23 et 24, le plateau-support 21 peut être réalisé dans un matériau métallique et, par exemple, de l'aluminium. Le fait de réaliser la totalité du dispositif de refroidissement dans un même matériau fortement conducteur de chaleur, permet une meilleure propagation de la chaleur depuis le plateau-support 21 jusqu'à la plaque emboutie 23. Autrement dit, un dispositif monomatière permet d'obtenir une meilleure conduction de la chaleur.

Comme on le voit sur la figure 2, la plaque emboutie 23 forme, par ses motifs d'emboutissage, des canaux de circulation d'eau. Des exemples de ces canaux sont référencés 25a et 25b. Ces canaux constituent des poches d'eau étanches, l'eau dans ces poches étant en mouvement permanent. L'étanchéité de ces poches 25a et 25b et, plus généralement, l'étanchéité du circuit de refroidissement est assurée par les joints de brasure 26 dont l'épaisseur et la surface influencent directement sur la tenue en pression.

La dimension et le nombre de canaux sont déterminés de façon à optimiser le coefficient d'échange entre le plateau-support 21 et le circuit de refroidissement 22. De même, la vitesse de l'eau dans les canaux est choisie pour optimiser ce coefficient d'échange. En effet, dans l'invention, on propose de modifier la vitesse de l'eau en insérant, dans les canaux de circulation, des déflecteurs de guidage 31 qui permettent, d'une part, de guider l'eau dans les canaux et, d'autre part, de modifier le débit d'eau dans ces canaux. On peut ainsi optimiser la vitesse de l'eau dans le circuit de refroidissement 22.

Sur la figure 3, on a représenté un exemple d'une plaque emboutie 23. Dans cet exemple, les canaux de circulation d'eau sont référencés 28. Ils peuvent correspondent approximativement aux canaux 25a et 25b montrés sur la figure 2. La plaque emboutie 23 comporte, en plus des canaux 28 de circulation d'eau, un canal d'arrivée d'eau 29 et un canal de sortie d'eau 30. Le canal d'arrivée 29 d'eau assure l'introduction de l'eau dans les canaux 28 et le canal de sortie 30 d'eau assure l'évacuation de l'eau hors des canaux 28. Ainsi, l'eau entre dans le circuit de refroidissement 22 par le canal d'arrivé 29, puis elle chemine dans les canaux de circulation 28 jusqu'au canal de sortie 30.

Les canaux 28 peuvent comporter des déflecteurs 31 formant rails de guidage pour l'eau. Le fait de guider l'eau dans les canaux permet de diminuer les pertes de charge et, en particulier, les pertes par changement de direction dues, notamment, aux virages des canaux. Par ailleurs, la présence de ces déflecteurs 31 permet d'augmenter la zone de contact entre l'eau et la plaque emboutie 23 ce qui permet d'augmenter la capacité de refroidissement du dispositif.

Les canaux de circulation d'eau 28 sont de préférence de sections constantes pour éviter les pertes de charge. Ils peuvent aussi comprendre des turbulateurs 32. Ces turbulateurs sont des petits éléments insérés dans les canaux 28 pour créer des turbulences, c'est-à-dire des mouvements d'eau. Ils peuvent être réalisés au moyen de petits éléments de formes variées, tels que des petits pics ou des petits trous placés dans les canaux. Ces turbulateurs permettent d'augmenter la turbulence de l'eau par deux effets : soit par le passage de l'eau dans des trous, soit par le passage de l'eau dans des gorges étroites. On obtient alors une accélération dans la circulation de l'eau. Ces turbulences ont l'avantage d'offrir un meilleur coefficient d'échange entre l'eau et le circuit de refroidissement et donc un refroidissement plus rapide de l'électronique de puissance.

Les turbulateurs 32, comme les déflecteurs 31, sont réalisés de préférence lors de l'emboutissage de la plaque emboutie 23, c'est-à-dire qu'ils sont réalisés en même temps que les canaux 28, 29 et 30.

Sur la figure 4, on a représenté, à titre d'exemple, un détail du dispositif de refroidissement de l'invention. Plus précisément, on a représenté la tubulure 27 qui assure l'arrivée et la sortie de l'eau dans le circuit de refroidissement 22. Cette tubulure 27 est une sorte de tube métallique, par exemple en aluminium, fixé aux extrémités des canaux d'arrivée 29 et de sortie 30 de l'eau. Cette tubulure 27 est placée perpendiculairement au circuit de refroidissement 22 et, plus précisément, à la plaque emboutie 23.

La tubulure 27 est montée par exemple sur le circuit de refroidissement 22 de la façon suivante :
- la tubulure est d'abord assemblée sur la semelle formée par le plateau-support 21 et/ou la plaque plane 24, par un montage serré ou par un léger sertissage.
- elle est ensuite brasée de façon à être solidaire du circuit de refroidissement 22.

Le brasage de la tubulure 27 peut se faire en même temps que le brasage de la plaque emboutie 23 par l'utilisation d'un plaquage situé sur la face supérieure de la plaque 24.

Dans le cas où le dispositif de refroidissement ne comporte pas de plaque plane 24, la tubulure 27 est alors fixée directement sur le plateau-support 21 par exemple au moyen d'un cordon de brasure.

Un anneau de brasage 33 peut également être prévu entre la tubulure et la semelle pour assurer encore une meilleure étanchéité de l'ensemble.

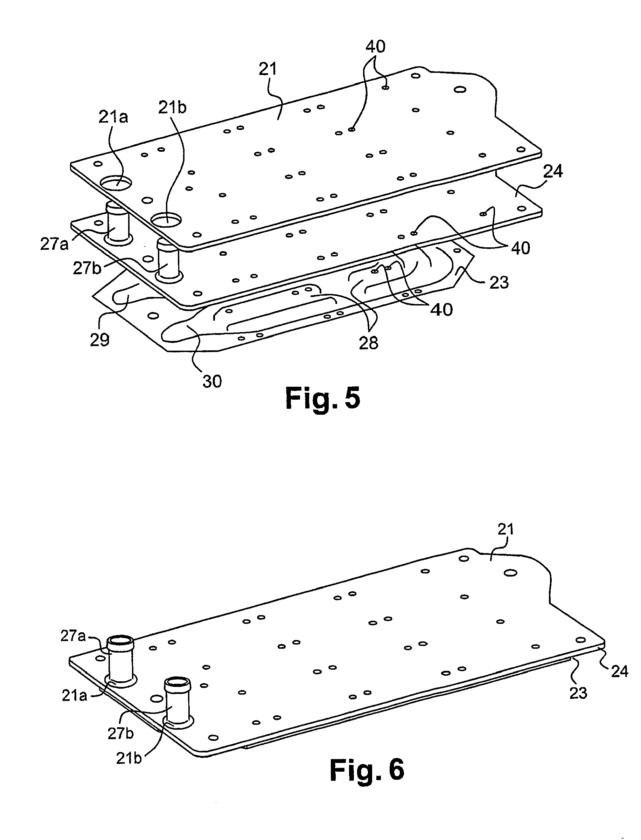

La figure 5 représente une vue en perspective éclatée d'un exemple de dispositif de refroidissement ne faisant pas partie de l'invention. Cette figure 5 montre les différentes plaques formant le dispositif de refroidissement, en particulier le plateau-support 21, la plaque plane 24 et la plaque emboutie 23. Selon le mode de réalisation de la figure 5, la tubulure 27 comporte une tubulure d'arrivée d'eau 27a et une tubulure de sortie d'eau 27b, parallèles l'une à l'autre. Ces deux tubulures 27a et 27b sont montées sur la plaque plane 24. Lors de l'assemblage des différentes plaques, les tubulures 27a et 27b sont introduites, respectivement, dans des orifices 21 a et 21 b du plateau-support 21. La plaque emboutie 23 est ensuite placée au-dessous de la plaque plane 24 de façon à ce que la tubulure 27a soit en regard du canal d'arrivée 29 de la plaque emboutie 23 et que la tubulure 27b soit en regard du canal de sortie 30 de la plaque emboutie 23.

La figure 6 représente le mode de réalisation du dispositif de refroidissement de l'invention de la figure 5, lorsque les différentes plaques sont assemblées de la façon expliquée précédemment. On voit donc, sur cette figure 6, le plateau-support 21 assemblé avec la plaque plane 24 et la plaque emboutie 23. La tubulure d'arrivée 27a traverse l'orifice 21a du plateau-support 21 et la tubulure de sortie 27b traverse l'orifice 21 b dudit plateau-support 21, permettant un branchement respectif sur des tuyaux extérieurs d'arrivée d'eau et d'évacuation d'eau.

Dans une variante de l'invention, la tubulure 27 peut être une seule et même pièce avec une entrée d'eau et une sortie d'eau. Dans ce cas, la forme des canaux d'arrivée et de sortie d'eau de la plaque emboutie 23 est adaptée pour recevoir et évacuer l'eau de/par cette pièce.

Dans une autre variante de l'invention, la tubulure 27 peut comporter plusieurs tubulures d'arrivée d'eau et/ou plusieurs tubulures de sortie d'eau.

Pour une intégration plus facile des différents éléments sur le plateau-support 21 et, en particulier, pour l'insertion de l'électronique de puissance 9, les différentes pièces à assembler peuvent, au préalable, être poinçonnées, c'est-à-dire marquées d'un poinçon de forme choisie. Ce poinçon peut être, par exemple, un orifice 40 d'un diamètre ou d'une forme particulière. Ce poinçon crée un repère mécanique sur chaque pièce. Ainsi, en superposant les poinçons de chaque pièce, par exemple au moyen de brides passant à travers ces orifices alignés de chaque plaque, on est alors sûr de superposer correctement les pièces. Ce poinçonnage permet ainsi de centrer les pièces les unes avec les autres, notamment lors de l'opération de brasage.

Ce poinçonnage peut être réalisé en même temps que le perçage d'orifices destinés au montage du ou des modules électronique 9 dans le plateau-support 21. En effet, pour fixer le module électronique 9 dans le dispositif de refroidissement, il est nécessaire de percer des orifices dans une partie au moins du dispositif de refroidissement pour permettre d'y emboîter des picots de positionnement présents sous le module électronique, ou pour permettre le passage de vis de fixations des modules électroniques. Ces orifices peuvent être réalisés soit dans le plateau-support 21, soit dans la semelle 21/24, soit dans la totalité du dispositif de refroidissement. C'est ce dernier cas qui est montré sur les figures 5 et 6, où les orifices sont référencés 40. Le choix du perçage d'une ou de plusieurs plaques du dispositif de refroidissement se fait en fonction de l'épaisseur de chacune des plaques et du plateau-support.

La réalisation d'un tel poinçonnage peut permettre d'éviter de réaliser des usinages supplémentaires coûteux après brasage du dispositif.

Le dispositif de refroidissement qui vient d'être décrit sur les figures 5 et 6 peut être fabriqué avec une technique de brasage. Dans ce cas,
- on réalise tout d'abord un circuit de refroidissement 22 en emboutissant une première plaque de métal pour obtenir une plaque emboutie 23,
- on fixe une tubulure 27 sur une plaque plane 24,
- on place la plaque plane 24 sur la plaque emboutie 23,
- on place un plateau-support 21 sur le plaque plane 24,
- on assemble ces trois plaques et on les insère dans un four où la température est portée au point de fusion souhaité.

Il est à noter qu'une couche de plaquage a préalablement été déposée par colaminage sur au moins une des plaques pour permettre la fusion entre les plaques, deux par deux. Par exemple, une couche de plaquage est déposée sur la face inférieure du plateau-support 21 et sur la face inférieure de la plaque plane 24 pour assurer la fusion entre, respectivement, le plateau-support 21 et la plaque plane 24 et entre la plaque plane 24 et la plaque emboutie 23.

Dans une autre mode de réalisation ne faisant pas partie de l'invention, par exemple seule la plaque intermédiaire 24 possède un plaquage sur ses deux faces.

De préférence, la face supérieure du plateau-support 21, c'est-à-dire la face qui est en contact avec l'électronique de puissance, est vierge de tout plaquage afin de garantir un meilleur état de surface, après brasage.

Le brasage de plaque emboutie 23 sur la plaque plane et le brasage de la plaque plane sur le plateau-support peuvent être réalisés simultanément, comme expliqué précédemment. De même, la tubulure 27 peut être brasée sur le circuit de refroidissement 22 en même temps que le brasage des plaques 23 et 24. Le brasage peut toutefois être réalisé en plusieurs étapes, pour des questions pratiques.

Le brasage des différentes plaques du dispositif de refroidisement de l'invention permet d'obtenir une continuité métallurgique, donc une continuité thermique entre ces différentes plaques.

En outre, la technique de brasage, sur un matériau tel que l'aluminium, permet d'obtenir un dispositif de refroidissement relativement léger par rapport aux dispositifs actuels.

Le dispositif de refroidissement de l'invention peut aussi être réalisé par des techniques autres que le brasage, par exemple par sérigraphie des motifs du circuit de refroidissement sur une plaque métallique, par exemple en aluminium. Il consiste ensuite à assembler cette plaque sérigraphiée avec une plaque plane et un plateau-support et à laminer l'ensemble au moyen d'un lamineur. Enfin, la plaque sérigraphiée est mise sous pression, par exemple avec de l'air comprimé acheminé par la tubulure 27, de façon à ce que les zones non sérigraphiées de la plaque sérigraphiée se séparent de la plaque plane, formant ainsi les canaux de circulation d'eau.

## Revendications

1. Dispositif de refroidissement d'une électronique **de puissance** (9) comportant un plateau-support (21) **sur une première face duquel** est montée l'électronique de puissance (9); un circuit de refroidissement (22) par circulation d'un liquide comprenant une première plaque de métal **emboutie** (23), le circuit de refroidissement (22) étant monté sous **une deuixème face du plateau-support** (21) **opposée à ladite première face** et comportant un canal d'arrivée (29) du liquide, un canal de sortie (30) du liquide et des canaux de circulation (28) du liquide entre le cana) d'arrivée et le canal de sortie; au moins une tubulure métallique (27) d'arrivée et de sortie du liquide fixée aux extrémités des canaux d'arrivée (29) et de sortie (30); **caractérisé en ce que** la tubulure métallique (27) est placée perpendiculairement au dessus de la première plaque de métal (23) **et fixée au niveau de ladite première face du plateau support (21)**.

2. Dispositif de refroidissement selon la revendication précédente, **caractérisé en ce que** le circuit de refroidissement comporte des déflecteurs (31) situés dans les canaux de circulation du liquide.

3. Dispositif de refroidissement selon l'une des revendications précédentes, **caractérisé en ce que** le circuit de refroidissement comporte des turbulateurs (32) répartis dans les canaux de circulation du liquide.

4. Dispositif de refroidissement selon l'une des revendications précédentes, **caractérisé en ce que** le circuit de refroidissement (22) comporte au moins une plaque intermédiaire de métal (24) fixée entre le plateau-support (21) et la première plaque de métal (23).

5. Dispositif de refroidissement selon l'une des revendications précédentes, **caractérisé en ce que** le plateau-support (21) est en aluminium.

6. Dispositif de refroidissement selon l'une des revendications précédentes, **caractérisé en ce que** la première plaque de métal (23) est en aluminium.

7. Procédé d'assemblage d'un dispositif de refroidissement de l'électronique de puissance selon la revendication 1, **caractérisé en ce qu'**il comporte les opérations suivantes : réalisation d'un circuit de refroidissement par emboutissage d'une première plaque de métal
- assemblage de la tubulure (27) avec le plateau-support (21) puis serrage ou sertissage,
- assemblage du circuit de refroidissement (22) sous le plateau-support (21),
- fixation du circuit de refroidissement (22) avec le plateau-support (21) et la tubulure (27) par brasage.

8. Procédé selon la revendication 7, **caractérisé en ce que** les canaux du circuit de refroidissement (22) sont réalisés par emboutissage de la première plaque de métal (23).

9. Procédé selon les revendications 2 et 8, **caractérisé en ce qu'**au moins un déflecteur (31) est réalisé par emboutissage de la première plaque de métal (23).

10. Procédé selon la revendication 4 et selon l'une quelconque des revendications 7 à 9, **caractérisé en ce que** la plaque intermédiaire de métal (24) est plane et brasée au dessus de la première plaque de métal (23).

11. Procédé selon les revendications 3 et 8, **caractérisé en ce qu'**au moins un turbulateur (32) est réalisé par emboutissage de la première plaque de métal (23).

12. Procédé selon l'une quelconque des revendications 7 à 11, caractérisé en que le plateau-support (21) comporte un plaquage par colaminage.

13. Procédé selon l'une quelconque des revendications 7 à 12, caractérisé en que la première plaque de métal (23) comporte un plaquage par colaminage.

## Patentansprüche

1. Vorrichtung zum Kühlen einer Leistungselektronik (9), die eine Trägerplatte (21), wovon auf einer ersten Seite die Leistungselektronik (9) montiert ist; einen Kühlungskreis (22) mittels Zirkulation einer Flüssigkeit, der eine erste tiefgezogene Metallplatte (23) aufweist, wobei der Kühlungskreis (22) unter einer zweiten Seite der Trägerplatte (21) gegenüber der ersten Seite montiert ist und einen Eingangskanal (29) für die Flüssigkeit, einen Ausgangskanal (30) für die Flüssigkeit und Zirkulationskanäle (28) für die Flüssigkeit zwischen dem Eingangskanal und dem Ausgangskanal umfasst; und wenigstens ein Metallrohr (27) für den Eintritt und den Austritt der Flüssigkeit, das an den Enden des Eingangskanals (29) und des Ausgangskanals (30) befestigt ist, umfasst, **dadurch gekennzeichnet, dass** das Metallrohr (27) senkrecht auf der ersten Metallplatte (23) angeordnet und auf Höhe der ersten Seite der Trägerplatte (21) befestigt ist.

2. Kühlungsvorrichtung nach dem vorhergehenden Anspruch, **dadurch gekennzeichnet, dass** der Kühlungskreis Ablenkeinrichtungen (31) aufweist, die sich in den Zirkulationskanälen für die Flüssigkeit befinden.

3. Kühlungsvorrichtung nach einem der vorhergehenden Ansprüche, **dadurch gekennzeichnet, dass** der Kühlungskreis Turbulenzerzeuger (32) aufweist, die in den Zirkulationskanälen für die Flüssigkeit verteilt sind.

4. Kühlungsvorrichtung nach einem der vorhergehenden Ansprüche, **dadurch gekennzeichnet, dass** der Kühlungskreis (22) wenigstens eine Metallzwischenplatte (24) aufweist, die zwischen der Trägerplatte (21) und der ersten Metallplatte (23) befestigt ist.

5. Kühlungsvorrichtung nach einem der vorhergehenden Ansprüche, **dadurch gekennzeichnet, dass** die Trägerplatte (21) aus Aluminium ist.

6. Kühlungsvorrichtung nach einem der vorhergehenden Ansprüche, **dadurch gekennzeichnet, dass** die erste Metallplatte (23) aus Aluminium ist.

7. Verfahren zum Montieren einer Kühlungsvorrichtung für Leistungselektronik nach Anspruch 1, **dadurch gekennzeichnet, dass** es die folgenden Operationen umfasst:
- Verwirklichen eines Kühlungskreises durch Tiefziehen einer ersten Metallplatte,
- Zusammenfügen des Rohres (27) mit der Trägerplatte (21), dann Klemmen oder Falzen,
- Zusammenfügen des Kühlungskreises (22) unter der Trägerplatte (21), und
- Befestigen des Kühlungskreises (22) mit der Trägerplatte (21) und dem Rohr (27) durch Hartlöten.

8. Verfahren nach Anspruch 7, **dadurch gekennzeichnet, dass** die Kanäle des Kühlungskreis (22) durch Tiefziehen der ersten Metallplatte (23) verwirklicht werden.

9. Verfahren nach den Ansprüchen 2 und 8, **dadurch gekennzeichnet, dass** wenigstens eine Ablenkeinrichtung (31) durch Tiefziehen der ersten Metallplatte (23) verwirklicht wird.

10. Verfahren nach Anspruch 4 und einem der Ansprüche 7 bis 9, **dadurch gekennzeichnet, dass** die Metallzwischenplatte (24) eben ist und auf der ersten Metallplatte (23) hartverlötet ist.

11. Verfahren nach den Ansprüchen 3 und 8, **dadurch gekennzeichnet, dass** wenigstens ein Turbulenzerzeuger (32) durch Tiefziehen der ersten Metallplatte (23) verwirklicht wird.

12. Verfahren nach einem der Ansprüche 7 bis 11, **dadurch gekennzeichnet, dass** die Trägerplatte (21) eine zusammenlaminierte Verkleidung umfasst.

13. Verfahren nach einem der Ansprüche 7 bis 12, **dadurch gekennzeichnet, dass** die erste Metallplatte (23) eine zusammenlaminierte Verkleidung umfasst.

## Claims

1. Device for cooling power electronics (9), comprising a support plate (21) on a first face of which power electronics (9) are mounted; a circuit (22) for cooling by circulation of a liquid, comprising a first stamped metal plate (23), the cooling circuit (22) being mounted below a second face of the support plate (21) opposed to the said first face and comprising a liquid inlet duct (29), a liquid outlet duct (30) and ducts (28) for circulating the liquid between the inlet duct and the outlet duct; at least one metal liquid inlet and outlet tube (27) fixed to the end of the inlet (29) and outlet (30) ducts; **characterized in that** the metal tube (27) is placed perpendicularly above the first metal plate (23) and fixed at the level of the said first face of the support plate (21).

2. Cooling device according to the preceding claim, **characterized in that** the cooling circuit comprises deflectors (31) situated in the liquid circulation ducts.

3. Cooling device according to either of the preceding claims, **characterized in that** the cooling circuit comprises turbulators (32) distributed in the liquid circulation ducts.

4. Cooling device according to one of the preceding claims, **characterized in that** the cooling circuit (22) comprises at least one intermediate metal plate (24) fixed between the support plate (21) and the first metal plate (23).

5. Cooling device according to one of the preceding claims, **characterized in that** the support plate (21) is made of aluminium.

6. Cooling device according to one of the preceding claims, **characterized in that** the first metal plate (23) is made of aluminium.

7. Method for assembling a device for cooling power electronics according to Claim 1, **characterized in that** it comprises the following operations:
- producing a cooling circuit by stamping a first metal plate,
- assembling the tube (27) with the support plate (21) followed by clamping or crimping,
- assembling the cooling circuit (22) below the support plate (21),
- fixing the cooling circuit (22) with the support plate (21) and the tube (27) by brazing.

8. Method according to Claim 7, **characterized in that** the cooling circuit ducts (22) are produced by stamping the first metal plate (23).

9. Method according to Claims 2 and 8, **characterized in that** at least one deflector (31) is produced by stamping the first metal plate (23).

10. Method according to Claim 4 and according to any one of Claims 7 to 9, **characterized in that** the intermediate metal plate (24) is planar and brazed above the first metal plate (23).

11. Method according to Claims 3 and 8, **characterized in that** at least one turbulator (32) is produced by stamping the first metal plate (23).

12. Method according to any one of Claims 7 to 11, **characterized in that** the support plate (21) comprises a plating by colamination.

13. Method according to any one of Claims 7 to 12, **characterized in that** the first metal plate (23) comprises a plating by colamination.
